# EUROPEAN PATENT SPECIFICATION

(11) **EP 3 837 928 B1**
(45) Date of publication and mention of the grant of the patent: **05.11.2025**
(21) Application number: 18808099.8
(22) Date of filing: 13.08.2018
(51) Int. Cl.: H05K 3/30, H05K 3/36, H05K 1/14, H05K 3/00, H05K 3/34

(54) **PCB STRUCTURES IN SMT**
PCB-STRUKTUREN IN SMT
STRUCTURES DE PCB EN SMT

(43) Date of publication of application: 23.06.2021
(73) Proprietor: Disruptive Technologies Research AS, 1366 Lysaker (NO)
(72) Inventor: MOLDSVOR, Oystein, 7092 Tiller (NO)
(74) Representative: Valet Patent Services Limited
(86) International application number: PCT/IB2018/001017
(87) International publication number: WO 2020/035711

(56) References cited:
- US-A- 5 894 648
- US-A1- 2006 107 524
- US-A1- 2011 271 522
- US-A1- 2013 329 389

## Description

### TECHNICAL FIELD

The present disclosure is related generally to electronic circuits and, more particularly, to systems and methods for providing three-dimensional (3D) structures in printed circuit boards (PCBs).

### BACKGROUND

In modern electronic circuits, a 3D shaped PCB part is often needed or desired. Although there may be techniques that could be adopted making 3D formed structures in PCBs, such existing techniques have generally unacceptable limitations. For example, in miniature circuits, existing technology requires that planar components (i.e., SMDs or surface mount devices) be placed relatively far from such non-planar parts of the structures. This greatly impacts circuit density and thus, the overall size of the resulting product. In addition the cost of 3D shaped PCBs produced using current technology can be significantly higher than normal PCBs, negatively impacting the cost- effectiveness of the product.

In an embodiment of US 2011/271522 A1 a method for making an electronic assembly is provided. The method comprises positioning a substrate having a plurality of segmented portions. A first segmented portion has a first plurality of conductive traces terminating to form a first plurality of conductive pads. A second segmented portion has a second plurality of conductive traces terminating to form a second plurality of conductive pads. A flex circuit is placed onto the conductive pads. The flex circuit includes a third plurality of conductive traces terminating at a first end to form a first plurality of connecting pads and terminating at a second end to form a second plurality of connecting pads. Electronic components are electrically coupled to the first and second plurality of conductive traces to form a primary PCB and a daughter PCB. The connecting pads are electrically coupled to the conductive pads for electrically coupling the daughter PCB to the primary PCB.

Additionally, the discussion of technology in this Background section is reflective of the inventors' own observations, considerations, and thoughts, and is in no way intended to be, to accurately catalog, or to comprehensively summarize any prior art reference or practice. As such, the inventors expressly disclaim this section as admitted or assumed prior art. Moreover, the identification or implication herein of one or more desirable courses of action reflects the inventors' own observations and ideas, and should not be assumed to indicate an art-recognized desirability.

### SUMMARY OF EMBODIMENTS

In an embodiment of the disclosed principles, a method is provided for creating a printed circuit board (PCB) with 3D structures. The method entails manufacturing from the same material a main PCB as well as a plurality of PCB pieces. The plurality of PCB pieces are loaded into a tape of a tape and reel assembly, which is them placed in a tape and reel placement machine associated with an SMT assembler. Processing of the main PCB through the assembler results in placement of one or more of the plurality of PCB pieces on the main PCB and finishing of the main PCB to permanently affix the one or more placed PCB pieces to the main PCB.

Manufacturing the plurality of PCB pieces may include Manufacturing multiple PCB pieces on one board and then separating the multiple PCB pieces from the board. Further, finishing the main PCB to permanently affix the one or more placed PCB pieces to the main PCB may include processing the main PCB via reflow soldering, or instead gluing the one or more placed PCB pieces to the main PCB. It will be appreciated that the placement machine may also be loaded with SMT components other than the PCB pieces. In an embodiment, the tape of the tape and reel assembly includes a plurality of slots and it is into these slots that the plurality of PCB pieces are loaded.

In another embodiment, a system is provided for creating a PCB having thereon 3D structures placed by SMT assembly. The system includes a PCB manufacturing line to manufacture from the same material a main PCB and a plurality of PCB pieces. A tape and reel assembly includes a tape, having loaded therein the plurality of PCB pieces. An SMT assembly includes an inlet for receiving the main PCB and a tape and reel placement machine loaded with the tape and reel assembly including the tape having loaded therein the plurality of PCB pieces. In this way, processing of the main PCB via the SMT assembly system yields the main PCB having one or more of the of PCB pieces permanently affixed thereto.

In a further embodiment, a plurality of PCB pieces are manufactured on a single board, and they are then separated therefrom. The affixing of the PCB pieces to the main PCB may be accomplished via a reflow soldering, or alternatively, the PCB pieces may be glued to the main PCB. In a further aspect, the tape includes a plurality of slots into which the plurality of PCB pieces are loaded, and this or another tape used by the assembly system may contain other SMTs as well.

Other features and advantages will be appreciated from the details description taken in conjunction with the attached figures.

### BRIEF DESCRIPTION OF THE SEVERAL VIEWS OF THE DRAWINGS

While the appended claims set forth the features of the present techniques with particularity, these techniques, together with their objects and advantages, may be best understood from the following detailed description taken in conjunction with the accompanying drawings of which:
Figure 1 is a top view of a PCB wherein the PCB contains multiple cavities for the installation of wiring;
Figure 2 is a pair of schematic cross-sectional views showing the use of cavities and embedding to create 3D structures in PCB technology;
Figure 3 is a top view of a PCB in accordance with an embodiment of the described principles wherein the PCB has multiple 3D structures;
Figure 4 is a perspective view of a tape and reel for installing 3D structures in accordance with an embodiment of the described principles;
Figure 5 is a perspective view of an SMT mounting system for use in accordance with an embodiment of the described principles;
Figure 6 is a flow chart showing a process for use in creating 3D PCB structures in accordance with an embodiment of the described principles;
Figure 7 is a top view of a PCB sheet having therein multiple individual PCB piece structures in accordance with an embodiment of the described principles;
Figure 8 is a top view of a PCB sheet showing multiple adjacent PCB piece structures after cutting in accordance with an embodiment of the described principles; and
Figure 9 is a perspective view of a component tape having an individual PCB piece structure mounted therein in accordance with an embodiment of the described principles.

### DETAILED DESCRIPTION

Before presenting a detailed discussion of embodiments of the disclosed principles, an overview of certain embodiments is given to aid the reader in understanding the later discussion. As noted above, it is not currently practical to generate 3D structures in PCBs, due to limitations on circuit density and product cost. However, this disclosure provides a practical system and method for creating such structures without sacrificing budget or circuit density.

In an embodiment of the disclosed principles, non-planar parts (parts that are 3D beyond the normal thickness of SMD components) of PCBs may be assembled using the same equipment that is used for placing normal SMD components. In overview, the procedure entails using a standard planar PCB, constructing a secondary PCB suitable for assembly on top of the first PCB, cutting the secondary PCB into the correct shape for mounting on top of the first PCB, making the secondary PCB pieces available to an SMT machine, e.g., by providing the pieces on tape-and-reel or in trays or other formats, placing the secondary PCB pieces on the first PCB using a standard SMT machine (and if desired placing other electronic components such as SMDs in the same flow) and running the assembly through reflow soldering to solder the different PCBs and components together forming a combined 3D structure.

The secondary PCB may be cut into suitable shape by using a standard routing process such as mechanical or laser routing. It may alternatively be diced using methods applied in semiconductor processing, e.g., where the entire piece is put on a special tape holding the individual pieces while being cut. The pieces are typically released from the tape either by heat or UV for placement into tape- and-reel or trays as desired. In this way, one can make 3D structures in PCBs with low cost using a method suitable for high volume production.

With this overview in mind, and turning now to a more detailed discussion in conjunction with the attached figures, the techniques of the present disclosure are illustrated as being implemented in or via a suitable environment. The following description is based on embodiments and examples within which or via which the disclosed principles may be implemented, and should not be taken as limiting the claims with regard to alternative embodiments that are not explicitly described herein.

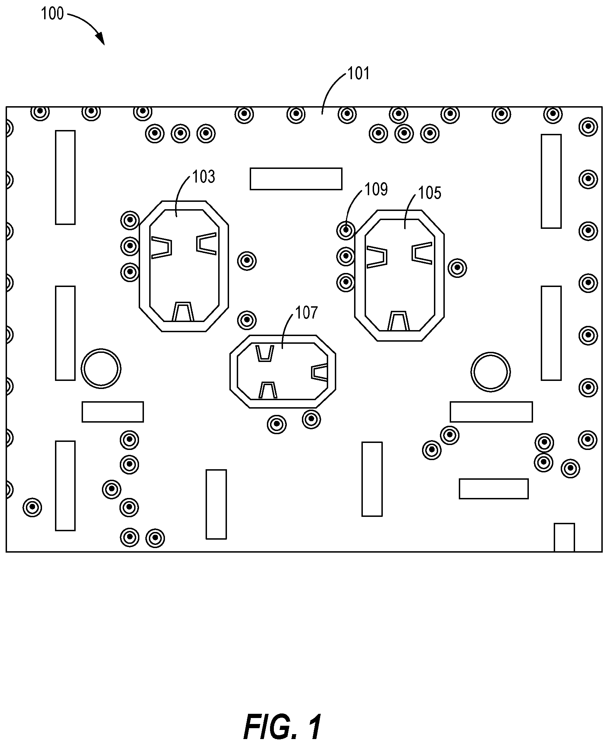

Referring now to Figure 1, this figure shows the use of cavities in a PCB to contain wiring. In particular, the illustrated PCB 100 has a planar surface 101 that includes numerous connection points 109 for SMTs. In addition, the surface 101 is interrupted in several areas by cavities 103, 105, 107 that are sunk downward into the surface 109.

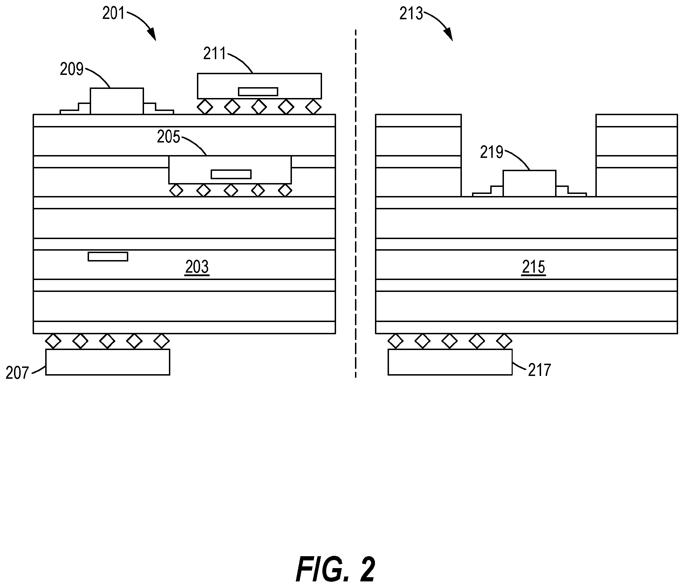

As noted above, it is also possible to embed components into the PCB. In this connection, Figure 2 is a schematic cross-sectional view illustrating, in a first portion 201, a PCB 203 having embedded therein a component 205. In addition, a number of surface mounted components 207, 209, 211 are shown. In a second portion 213 of Figure 2, an embedded component 219 is shown within a PCB 215. A surface mounted component 217 is also shown.

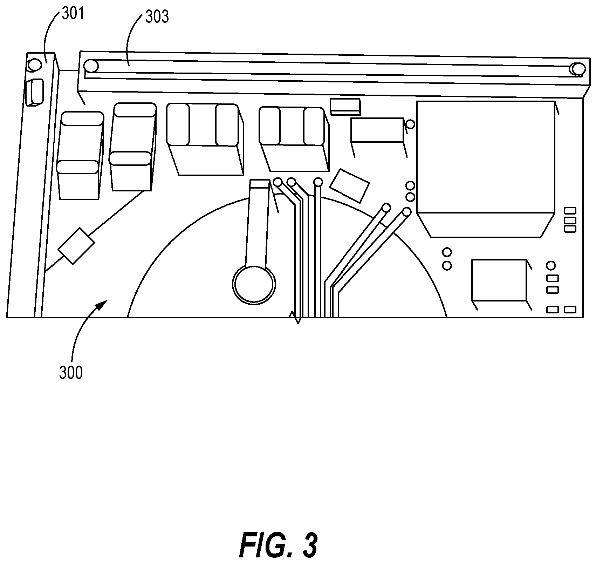

Figure 3 shows a PCB architecture in keeping with an embodiment of the disclosed principles, wherein 3D structures are created without the use of embedding or cavities in the board. In an embodiment, this is achieved by making a new component in the same material as the PCB and treating it like another standard SMT component. Thus, in the illustrated embodiment, structures in the PCB material extend up from the surface of the PCB as shown.

In particular, extended pieces of PCB material 301, 303 with integrated wiring are mounted on the board in the same way that SMT components such as resistors and capacitors are mounted. The raised structures 301, 303 extend above the board by any desired height. As with other SMT components, the new PCB components 301, 303 may be mounted to the main board 300 via their electrical connections, e.g., via conductive posts.

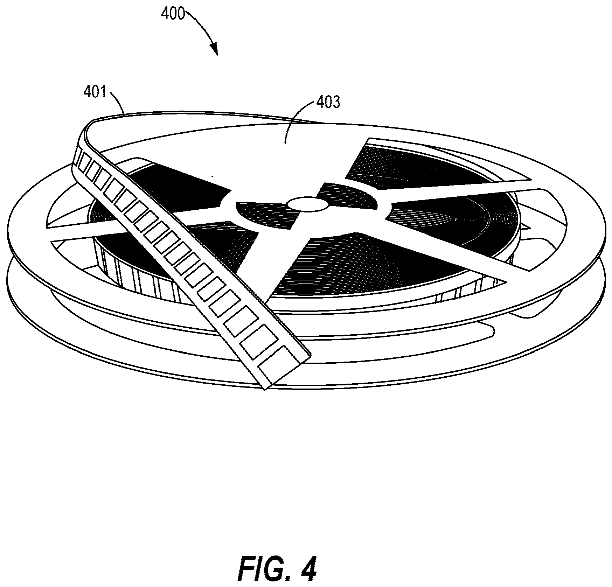

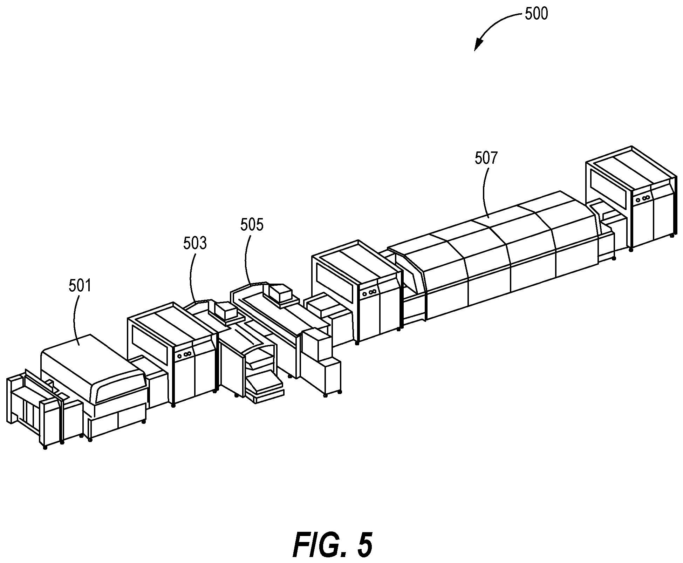

The new PCB components 301, 303 may be supplied on tape and reel as with, and even along with, other SMT components. For full understanding, a typical SMT tape and reel set 400 is shown in Figure 4, including both a tape 401 and reel 403. In operation, as shown in the perspective system diagram of Figure 5, parts are picked from the tape and placed onto the PCB in a traditional SMT process flow. In particular, the stencil printer 501 applies the solder paste to the PCB. The placement machines 503, 505 pick parts from the tape and places them on the PCB on top of the solder paste, and the components are then soldered to the PCB by heating in the reflow oven 507.

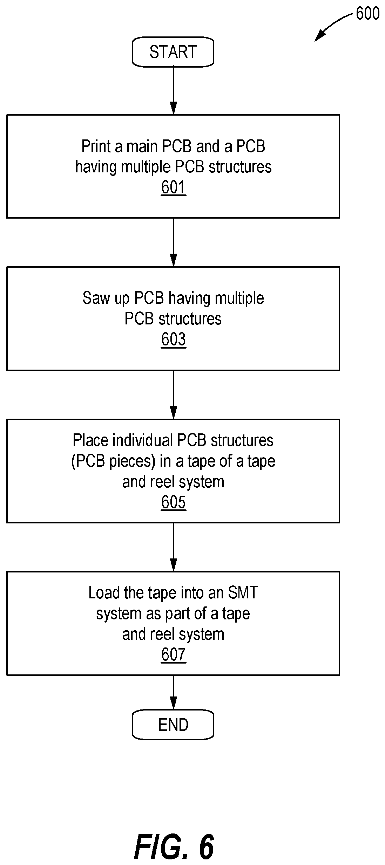

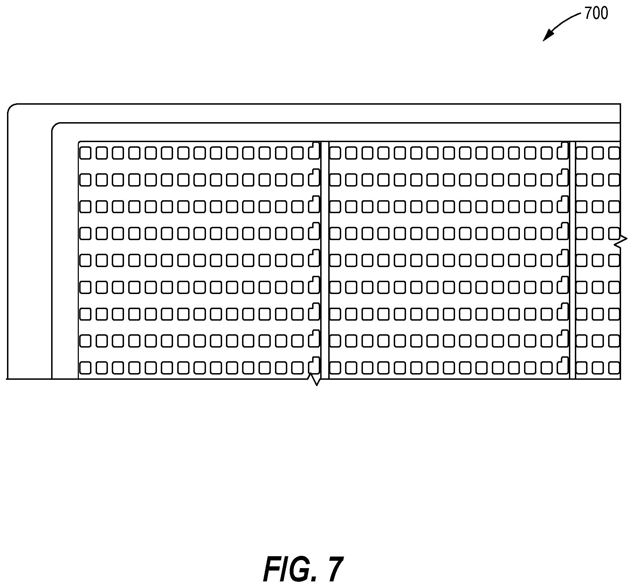

With these various systems, structures and components in mind, Figure 6 is a flow chart showing process steps used in an embodiment to create a PCB having 3D components. At stage 601 of the process 600, the maker constructs a main PCB as well as a parts PCB board having thereon one or more (typically more) PCB structures (or "PCB pieces"), and potentially though not invariably having other SMT components thereon. An example of such a PCB is shown in Figure 7, view 700. It should be ensured that these PCB structures have sufficient and appropriate metallization on the bottom side, which will be in contact with the main PCB, matching the main PCB. This will allow electrical contact between the main PCB and the PCB structure mounted on top. In an alternative embodiment, the SMT structures are glued to the main PCB, in which case metallization may not be required.

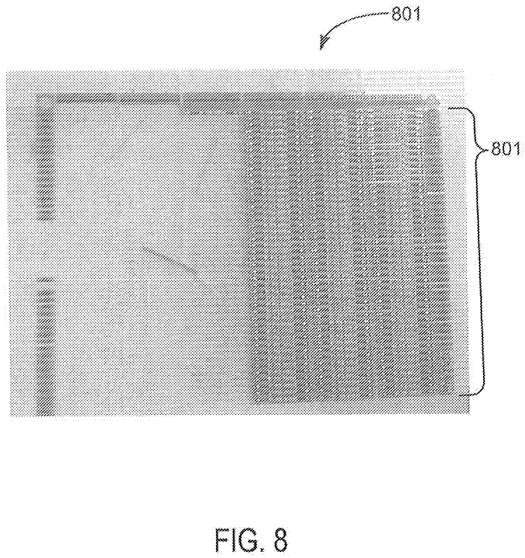

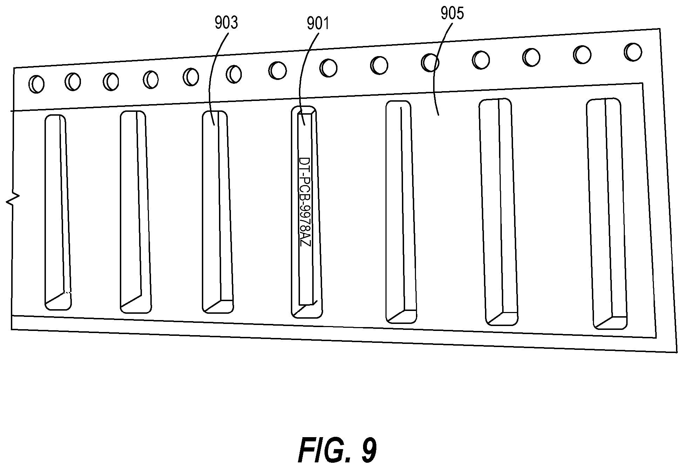

At stage 603, the created PCB panel 800 is divided, e.g., sawed, into individual pieces 801 as shown in Figure 8. The individual pieces 801 are then placed in a tape and reel system at stage 605 as also shown in Figure 9. In the figure, it can be seen that an individual PCB piece 901 (e.g., one of elements 801) is placed within a slot 903 in the tape 905 of a reel and tape system.

At stage 607, the tape 905 is loaded into an SMT system (e.g., as shown in Figures 4 and 5) as part of a tape and reel system, in the same way it would be if it contained ordinary electronic components. The main PCB is then processed through the SMT system at stage 609, including a stencil printer that applies the solder paste to the main PCB, one or more placement machines that pick parts from the tape and place them on the main PCB on top of the solder paste, and a reflow oven that heats the solder and thus he solders the PCB structures and any other SMTs to the main PCB. As a result, the individual piece 901 is soldered onto the main PCB.

It will be appreciated that various systems and processes have been disclosed herein. However, in view of the many possible embodiments to which the principles of the present disclosure may be applied, it should be recognized that the embodiments described herein with respect to the drawing figures are meant to be illustrative only and should not be taken as limiting the scope of the claims. Therefore, the techniques as described herein contemplate all such embodiments as may come within the scope of the following claims and equivalents thereof.

## Claims

1. A method for creating a printed circuit board (PCB) with 3D structures, the method comprising:
manufacturing a main PCB (800) and a plurality of PCB pieces (801), wherein the main PCB and the plurality of PCB pieces are made of the same material;
loading the plurality of PCB pieces (801) into a tape (905) of a tape and reel assembly;
processing the main PCB (800) through an assembler including a tape and reel placement machine (503, 505) loaded with the tape and reel assembly, whereby one or more of the plurality of PCB pieces (801) is placed on the main PCB (800); and
finishing the main PCB (800) to permanently affix the one or more placed PCB pieces (801) to the main PCB (800).

2. The method in accordance with claim 1, wherein manufacturing the plurality of PCB pieces (801) comprises manufacturing multiple PCB pieces (801) on one board and wherein the method further comprises separating the multiple PCB pieces (801) from the one board.

3. The method in accordance with claim 1, wherein finishing the main PCB (800) to permanently affix the one or more placed PCB pieces (801) to the main PCB (800) further comprises processing the main PCB (800) via reflow soldering.

4. The method in accordance with claim 1, wherein finishing the main PCB (800) to permanently affix the one or more placed PCB pieces (801) to the main PCB (800) further comprises gluing the one or more placed PCB pieces (801) to the main PCB (800).

5. The method in accordance with claim 1, wherein a tape (401) loaded in the tape and reel picker is loaded with SMT components other than the PCB pieces (801).

6. The method in accordance with claim 1, wherein manufacturing the plurality of PCB pieces (801) includes applying metallization on a bottom side of the PCB pieces (801).

7. The method in accordance with claim 6, wherein the applied metallization is sized and located to match contact points on the main PCB (800).

8. The method in accordance with claim 1, wherein the tape (905) of the tape and reel assembly includes a plurality of slots (903) and wherein loading the plurality of PCB pieces (801) into the tape (905) comprises loading each PCB piece (801) into one of the slots (903).

9. A system for creating a printed circuit board (PCB) with 3D structures, according to claim 1-8, comprising:
means for manufacturing a main PCB (800) and a plurality of PCB pieces (801), wherein the main PCB and the plurality of PCB pieces are made of the same material;
a tape and reel assembly including a tape (905), having loaded therein the plurality of PCB pieces (801); and
an SMT, Surface Mount Technology assembly system configured to place SMT components and the plurality of PCB pieces on PCBs and affix them therereto, the SMT assembly system having an inlet for receiving the main PCB (800), a tape and reel placement machine (503, 505) loaded with the tape and reel assembly including the tape (905) having loaded therein the plurality of PCB pieces (801), whereby processing of the main PCB via the SMT assembly system yields the main PCB (800) having one or more of the of PCB pieces (801) permanently affixed thereto.

10. The system in accordance with claim 9, wherein the SMT assembly system comprises a reflow oven (507).

11. The system in accordance with claim 9, wherein the tape and reel assembly also includes a tape (401) having loaded therein SMT components other than the PCB pieces (801).

12. The system in accordance with claim 9, wherein the SMT assembly system comprises a metallization unit for applying metallization on a bottom side of the PCB pieces (801).

13. The system in accordance with claim 13, wherein the metallization unit is configured to produce metallization on the PCB pieces (801) that is sized and located to match contact points on the main PCB (800).

14. The system in accordance with claim 9, wherein the tape (905) includes a plurality of slots (903) into which the plurality of PCB pieces (801) are loaded.

## Patentansprüche

1. Verfahren zum Erstellen einer Leiterplatte (PCB) mit 3D-Strukturen, wobei das Verfahren umfasst:
Herstellen einer Haupt-PCB (800) und einer Vielzahl von PCB-Stücken (801), wobei die Haupt-PCB und die Vielzahl von PCB-Stücken aus demselben Material bestehen;
Laden der Vielzahl von PCB-Stücken (801) auf ein Band (905) einer Band- und Spulenanordnung;
Verarbeiten der Haupt-PCB (800) durch einen Assembler, der eine mit der Band- und Spulenanordnung beladene Band- und Spulenplatzierungsmaschine (503, 505) umfasst, wobei ein oder mehrere der Vielzahl von PCB-Stücken (801) auf der Haupt-PCB (800) platziert werden; und
Fertigstellen der Haupt-PCB (800), um das eine oder die mehreren platzierten PCB-Stücke (801) dauerhaft an der Haupt-PCB (800) zu befestigen.

2. Verfahren nach Anspruch 1, wobei das Herstellen der Vielzahl von PCB-Stücken (801) das Herstellen mehrerer PCB-Stücke (801) auf einer Platte umfasst, und wobei das Verfahren ferner das Trennen der mehreren PCB-Stücke (801) von der einen Platte umfasst.

3. Verfahren nach Anspruch 1, wobei das Fertigstellen der Haupt-PCB (800), um das eine oder die mehreren platzierten PCB-Stücke (801) dauerhaft an der Haupt-PCB (800) zu befestigen, ferner das Verarbeiten der Haupt-PCB (800) mittels Reflow-Löten umfasst.

4. Verfahren nach Anspruch 1, wobei das Fertigstellen der Haupt-PCB (800), um das eine oder die mehreren platzierten PCB-Stücke (801) dauerhaft an der Haupt-PCB (800) zu befestigen, ferner das Aufkleben des einen oder der mehreren platzierten PCB-Stücke (801) auf die Haupt-PCB (800) umfasst.

5. Verfahren nach Anspruch 1, wobei ein in den Band- und Spulengreifer geladenes Band (401) mit anderen SMT-Komponenten als den PCB-Stücken (801) geladen wird.

6. Verfahren nach Anspruch 1, wobei das Herstellen der Vielzahl von PCB-Stücken (801) das Aufbringen einer Metallisierung auf einer Unterseite der PCB-Stücke (801) umfasst.

7. Verfahren nach Anspruch 6, wobei die aufgebrachte Metallisierung so bemessen und angeordnet ist, dass sie mit den Kontaktpunkten auf der Haupt-PCB (800) übereinstimmt.

8. Verfahren nach Anspruch 1, wobei das Band (905) der Band- und Spulenanordnung eine Vielzahl von Schlitzen (903) umfasst, und wobei das Laden der Vielzahl von PCB-Stücken (801) in das Band (905) das Laden jedes PCB-Stücks (801) in einen der Schlitze (903) umfasst.

9. System zum Erstellen einer Leiterplatte (PCB) mit 3D-Strukturen nach Anspruch 1-8, umfassend:
Mittel zum Herstellen einer Haupt-PCB (800) und einer Vielzahl von PCB-Stücken (801), wobei die Haupt-PCB und die Vielzahl von PCB-Stücken aus demselben Material bestehen;
eine Band- und Spulenanordnung, die ein Band (905) umfasst, auf dem die Vielzahl von PCB-Stücken (801) geladen ist; und
ein SMT-, Oberflächenmontagetechniks-, Anordnungssystem, das so konfiguriert ist, dass es SMT-Komponenten und die Vielzahl von PCB-Stücken auf PCB platziert und sie dort befestigt, wobei das SMT-Anordnungssystem einen Einlass zum Aufnehmen der Haupt-PCB (800), eine Band- und Spulenplatzierungsmaschine (503, 505) aufweist, die mit der Band- und Spulenanordnung beladen ist, die das Band (905) umfasst, in das die Vielzahl von PCB-Stücken (801) geladen ist, wobei die Verarbeitung der Haupt-PCB durch das SMT-Anordnungssystem die Haupt-PCB (800) ergibt, auf der ein oder mehrere der PCB-Stücke (801) dauerhaft befestigt sind.

10. System nach Anspruch 9, wobei das SMT-Anordnungssystem einen Reflow-Ofen (507) umfasst.

11. System nach Anspruch 9, wobei die Band- und Spulenanordnung auch ein Band (401) umfasst, das mit anderen SMT-Komponenten als den PCB-Stücken (801) geladen wird.

12. System nach Anspruch 9, wobei das SMT-Anordnungssystem eine Metallisierungseinheit zum Aufbringen einer Metallisierung auf einer Unterseite der PCB-Stücke (801) umfasst.

13. System nach Anspruch 13, wobei die Metallisierungseinheit so konfiguriert ist, dass sie auf den PCB-Stücken (801) eine Metallisierung erzeugt, die so bemessen und angeordnet ist, dass sie mit den Kontaktpunkten auf der Haupt-PCB (800) übereinstimmt.

14. System nach Anspruch 9, wobei das Band (905) eine Vielzahl von Schlitzen (903) umfasst, in die die Vielzahl von PCB-Stücken (801) geladen wird.

## Revendications

1. Procédé de création d'une carte de circuit imprimé (PCB) avec des structures 3D, le procédé comprenant :
la fabrication d'une carte PCB principale (800) et d'une pluralité de pièces de carte PCB (801), dans lequel la carte PCB principale et la pluralité de pièces de carte PCB sont constituées du même matériau ;
le chargement de la pluralité de pièces de carte PCB (801) dans une bande (905) d'un ensemble bande et bobine ;
le traitement de la carte PCB principale (800) au moyen d'un assembleur comportant une machine de placement de bande et de bobine (503, 505) chargée avec l'ensemble bande et bobine, moyennant quoi une ou plusieurs de la pluralité de pièces de carte PCB (801) est/sont placée(s) sur la carte PCB principale (800) ; et
la finition de la carte PCB principale (800) pour fixer de manière permanente la ou les pièce(s) de carte PCB (801) placée(s) à la carte PCB principale (800).

2. Procédé selon la revendication 1, dans lequel la fabrication de la pluralité de pièces de carte PCB (801) comprend la fabrication de multiples pièces de carte PCB (801) sur une carte unique et dans lequel le procédé comprend en outre la séparation des multiples pièces de carte PCB (801) de la carte unique.

3. Procédé selon la revendication 1, dans lequel la finition de la carte PCB principale (800) pour fixer de manière permanente la ou les pièce(s) de carte PCB (801) placée(s) à la carte PCB principale (800) comprend en outre le traitement de la carte PCB principale (800) par brasage par refusion.

4. Procédé selon la revendication 1, dans lequel la finition de la carte PCB principale (800) pour fixer de manière permanente la ou les pièce(s) de carte PCB (801) placée(s) à la carte PCB principale (800) comprend en outre le collage de la ou des pièce(s) de carte PCB (801) placée(s) à la carte PCB principale (800).

5. Procédé selon la revendication 1, dans lequel une bande (905) chargée dans la cassette de bande et de bobine est chargée avec des composants TMS autres que les pièces de carte PCB (801).

6. Procédé selon la revendication 1, dans lequel la fabrication de la pluralité de pièces de carte PCB (801) comporte l'application d'une métallisation sur un côté inférieur des pièces de carte PCB (801).

7. Procédé selon la revendication 6, dans lequel la métallisation appliquée est dimensionnée et localisée pour correspondre à des points de contact sur la carte PCB principale (800).

8. Procédé selon la revendication 1, dans lequel la bande (905) de l'ensemble bande et bobine comporte une pluralité de fentes (903) et dans lequel le chargement de la pluralité de pièces de carte PCB (801) dans la bande (905) comprend le chargement de chaque pièce de carte PCB (801) dans l'une des fentes (903).

9. Système de création d'une carte de circuit imprimé (PCB) avec des structures 3D selon la revendication 1 à 8, comprenant :
des moyens de fabrication d'une carte PCB principale (800) et d'une pluralité de pièces de carte PCB (801), dans lequel la carte PCB principale et la pluralité de pièces de carte PCB sont constituées du même matériau ;
un ensemble bande et bobine comportant une bande (905), dans laquelle est chargée la pluralité de pièces de carte PCB (801) ; et
un système d'assemblage par la Technique de Montage en Surface, TMS, configuré pour placer des composants TMS et la pluralité de pièces de carte PCB sur des cartes PCB et les fixer sur celles-ci, le système d'assemblage par TMS présentant une entrée pour recevoir la carte PCB principale (800), une machine de placement de bande et de bobine (503, 505) chargée avec l'ensemble bande et bobine comportant la bande (905) dans laquelle est chargée la pluralité de pièces de carte PCB (801), moyennant quoi le traitement de la carte PCB principale via le système d'assemblage par TMS produit la carte PCB principale (800) présentant une ou plusieurs des pièces de carte PCB (801) fixée(s) de manière permanente à celle-ci.

10. Système selon la revendication 9, dans lequel le système d'assemblage TMS comprend un four de refusion (507).

11. Système selon la revendication 9, dans lequel l'ensemble bande et bobine comporte également une bande (401) dans laquelle sont chargés des composants TMS autres que les pièces de carte PCB (801).

12. Système selon la revendication 9, dans lequel le système d'assemblage TMS comprend une unité de métallisation pour appliquer une métallisation sur un côté inférieur des pièces de carte PCB (801).

13. Système selon la revendication 13, dans lequel l'unité de métallisation est configurée pour produire une métallisation sur les pièces de carte PCB (801) qui est dimensionnée et localisée pour correspondre à des points de contact sur la carte PCB principale (800).

14. Système selon la revendication 9, dans lequel la bande (905) comporte une pluralité de fentes (903) dans lesquelles la pluralité de pièces de carte PCB (801) est chargée.
